# EUROPEAN PATENT SPECIFICATION

(11) **EP 1 681 911 B1**
(45) Date of publication and mention of the grant of the patent: **25.07.2007**
(21) Application number: 05000860.6
(22) Date of filing: 17.01.2005
(51) Int. Cl.: H05K 7/20, F28D 15/02, H01L 23/46

(54) **Heat-dissipating device with isothermal plate assembly of predetermined shape and method for manufacturing the same**
Wärmeableitvorrichtung mit isothermischer Plattenanordnung von gewünschter Form und Herstellungsverfahren
Dissipateur de chaleur avec ensemble de plaques isothermique de forme prédeterminée et son procédé de fabrication

(43) Date of publication of application: 19.07.2006
(73) Proprietor: CPUMATE INC., Taipei County 248 (TW)
(72) Inventor: Lin, Kuo-Len, Taipei County 248 (TW); Tsui, Hui-Min, Taipei County 248 (TW); Hsu, Ken, Taipei County 248 (TW)
(74) Representative: Urner, Peter

(56) References cited:
- NL-A- 9 400 082
- US-A1- 2003 011 990
- PATENT ABSTRACTS OF JAPAN vol. 2000, no. 25, 12 April 2001 (2001-04-12) & JP 2001 223308 A (TS HEATRONICS CO LTD), 17 August 2001 (2001-08-17)

## Description

### BACKGROUND OF THE INVENTION

### Field of the Invention

The present invention relates to a heat-dissipating device with isothermal plate assembly of predetermined shape and method for manufacturing the same, and more particularly to a heat-dissipating device with isothermal plate assembly of predetermined shape and manufactured by low cost and high yield process.

### Description of Prior Art

The conventional isothermal plate for heat-dissipating device of electronic apparatus is manufactured by a high thermally conductive material. The thermally conductive material is manufactured into a flat plate with a hollow accommodation space defined therein and containing wicked structure. The isothermal plate further comprises a wavy supporting unit arranged in the hollow accommodation space and used to support walls between an upper plate and a lower plate. The isothermal plate is then filled with working fluid and the accommodation space is sealed.

However, the isothermal plate described in above-mentioned process can only form plate-like structure because the conventional isothermal plate adopts non-vacuum structure. The conventional isothermal plate has crack problem when it is bent from flat state or its shape is varied due to temperature change. The yield of the conventional isothermal plate is degraded. Furthermore, due to the flat shape of the conventional isothermal plate, the electronic apparatus are arranged on one side of the isothermal plate, and the heat-dissipating fins are arranged on another side of the isothermal plate. The heat-dissipating device is difficult to be made compact and the heat-dissipating effect is influenced.

From US-A-2003/0011990 there is known moreover a method for manufacturing a heat dissipating device, the heat dissipating device comprising a plate assembly, which is not bent and has an upper plate and a lower plate and a bending heat pipe placed therein, the heat dissipating device further comprising a heat dissipating unit, the method comprising the steps of :
providing the upper plate and the lower plate with an accommodation groove defined therein.

### SUMMARY OF THE INVENTION

The present invention is to provide a heat-dissipating device as claimed with isothermal plate assembly of predetermined shape and manufactured by low cost and high yield process. The isothermal plate assembly is composed of an upper plate, a lower plate, and a heat pipe. The upper plate, the lower plate, and the heat pipe can be bent to a predetermined shape to assemble to the isothermal plate assembly with predetermined geometric shape. The heat-dissipating unit with corresponding shape is abutted to the isothermal plate assembly, thus forming the heat-dissipating device with isothermal plate assembly for various shapes.

Accordingly, the present invention provides a manufacturing method as claimed in claim 1 or 5 for a heat-dissipating device with isothermal plate assembly of predetermined shape. An upper plate and a lower plate with predetermined shape are provided and an accommodation groove is defined therein. A flattened heat pipe is bent into the predetermined shape and placed into the accommodation space. A binding agent is applied on the face between the heat pipe, the upper plate and the lower plate. A heat-dissipating unit composed of a plurality of heat-dissipating fins is assembled to a concave portion of the isothermal plate assembly of the predetermined shape. The upper plate and the lower plate are assembled with outer coupling unit and then a hot melting process is executed. The resultant product is then cooled to form a finished heat-dissipating device with an isothermal plate assembly of predetermined shape.

Moreover, the present invention provides a heat-dissipating device with isothermal plate assembly of predetermined shape. The heat-dissipating device comprises an isothermal plate assembly bent in a predetermined shape and composed of an upper plate and a lower plate, and an accommodation groove defined between the upper plate and the lower plate; at least one heat pipe being bent to the predetermined shape and placed into the accommodation groove; and a heat-dissipating unit composed of a plurality of heat-dissipating fins and assembled to the isothermal plate assembly of the predetermined shape.

The above summaries are intended to illustrate exemplary embodiments of the invention, which will be best understood in conjunction with the detailed description to follow, and are not intended to limit the scope of the appended claims.

### BRIEF DESCRIPTION OF DRAWING

The features of the invention believed to be novel are set forth with particularity in the appended claims. The invention itself however may be best understood by reference to the following detailed description of the invention, which describes certain exemplary embodiments of the invention, taken in conjunction with the accompanying drawings in which:
Fig. 1 is a flowchart of method for manufacturing the isothermal plate assembly according to a preferred embodiment of the present invention.
Fig. 2 is a perspective view of the isothermal plate assembly according to a preferred embodiment of the present invention.
Fig. 3 is a sectional view of the isothermal plate assembly according to a preferred embodiment of the present invention.
Fig. 4 is a sectional view of the isothermal plate assembly according to another preferred embodiment of the present invention.
Fig. 5 is a sectional view of the isothermal plate assembly according to still another preferred embodiment of the present invention.
Fig. 6 is a perspective view of the isothermal plate assembly according to another preferred embodiment of the present invention.
Fig. 7 is a perspective view of the isothermal plate assembly according to still another preferred embodiment of the present invention.

### DETAILED DESCRIPTION OF THE INVENTION

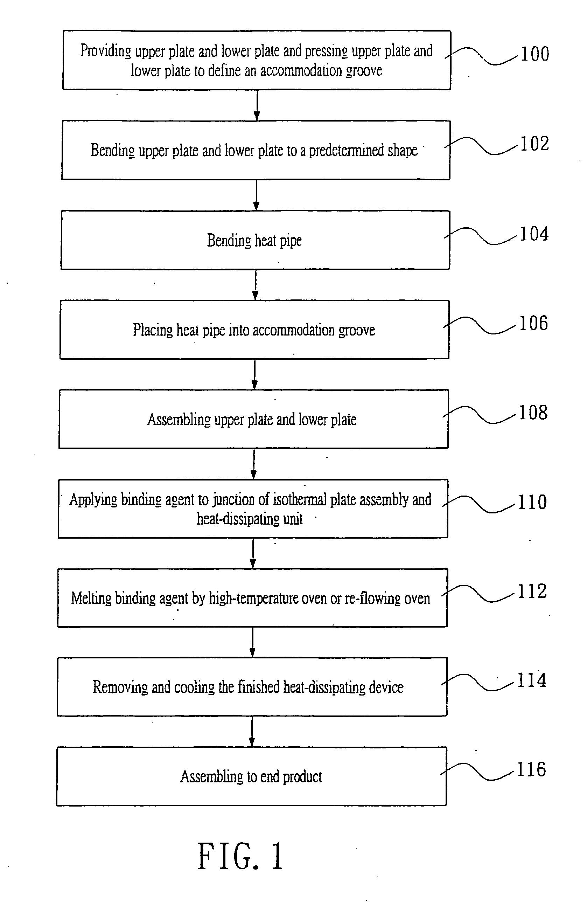

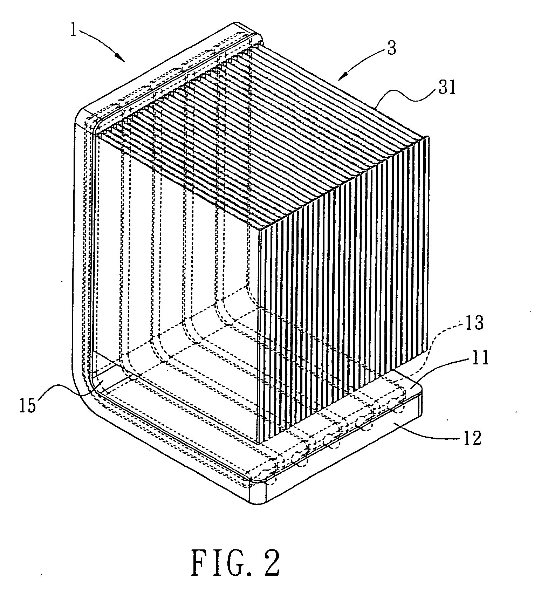

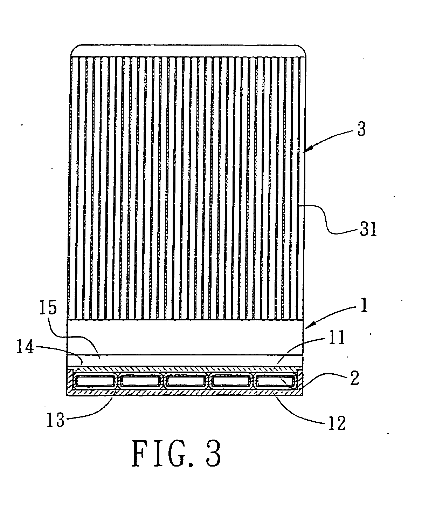

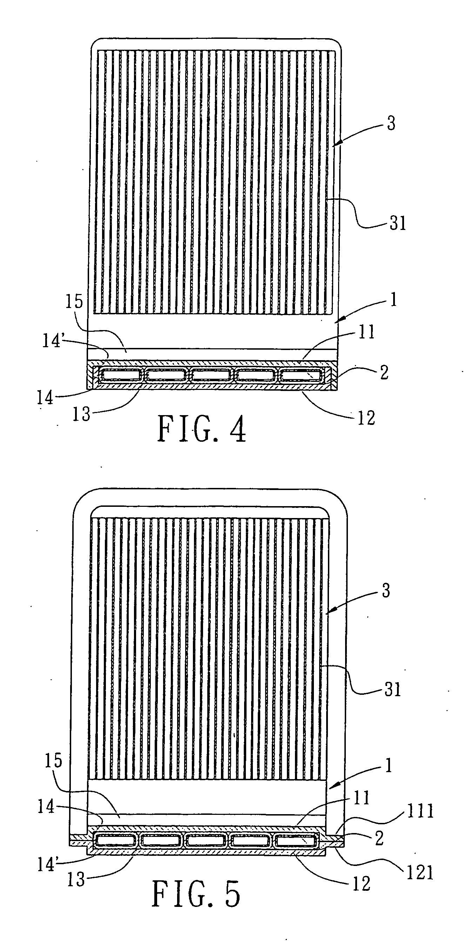

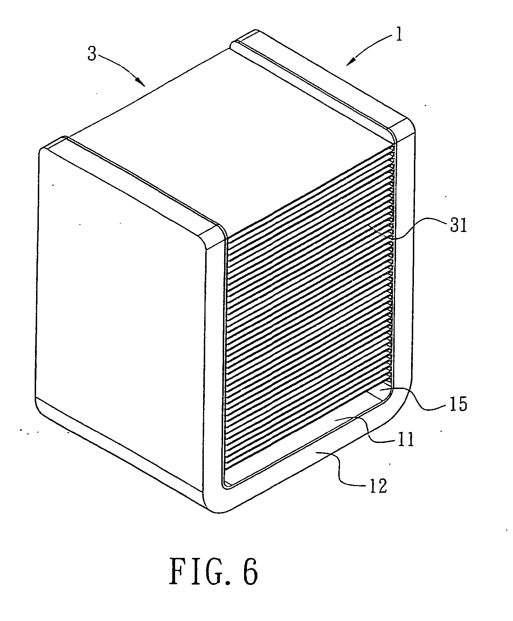

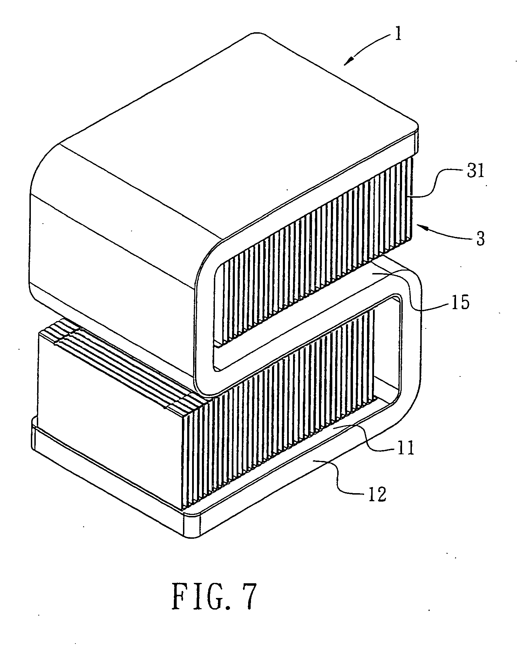

Fig. 1 shows the flowchart of method for manufacturing the heat-dissipating device with isothermal plate assembly of predetermined shape according to a preferred embodiment of the present invention, which comprises following steps:
Step 100: Providing an upper plate 11 and a lower plate 12, those plates being assembled to form an isothermal plate assembly 1, pressing on opposite faces of the upper plate 11 and the lower plate 12 to define an accommodation groove 13 as shown in Figs. 3 to 5.
Step 102: Bending the upper plate 11 and the lower plate 12 to a predetermined shape such as L shape shown in Fig. 2, U shape shown in Fig. 6 or S shape shown in Fig. 7.
Step 104: Providing at least one flattened flat heat pipe 2 and bending the heat pipe 2 with the shape corresponding to the upper plate 11 and the lower plate 12 as shown in Fig. 2.
Step 106: Placing the heat pipe 2 with bending shape formed in step 104 to the accommodation groove 13 formed in step 102 and applying binding agent to contact faces between the heat pipe 2 and the upper plate 11 and the lower plate 12. The binding agent is, for example, tin paste or 4450 glue, and could be hot-melted later to fill the gap between the heat pipe 2 and the upper plate 11 and the lower plate 12, and to assemble the heat pipe 2 and the upper plate 11 and the lower plate 12 together, as shown in Fig. 2.
Step 108: Assembling the upper plate 11 and the lower plate 12 together, wherein the heat pipe 2 in the accommodation groove 13 is also assembled together, as shown in Figs. 2 and 4. To enhance the hermetic degree between the upper plate 11 and the lower plate 12, the binding agent is subjected to a following-up thermal-melting process. The upper plate 11 and the lower plate 12 can be assembled by one of riveting, snap locking, embedding, spot-welding, screwing, and glue-pasting step.
Step 110: Providing a heat-dissipating unit 3 composed with a plurality of heat-dissipating fins 31 and assembling the heat-dissipating unit 3 to a concave portion 15 on the isothermal plate assembly 1, applying a binding agent to junction of the heat-dissipating unit 3 and the concave portion 15, wherein the heat-dissipating unit 3 and the concave portion 15 can be kept in contacting state by using a clamper.
Step 112: Sending heat-dissipating unit 3 applied with the binding agent and the isothermal plate assembly 1 to a high-temperature oven or a re-flowing oven to melt the binding agent between the heat-dissipating unit 3 and the concave portion 15, thus producing a finished heat-dissipating device with isothermal plate assembly.
Step 114: Removing the finished heat-dissipating device formed in step 112 from oven and cooling the finished heat-dissipating device with isothermal plate assembly.
Step 116: The cooled and finished heat-dissipating devices are assembled to end product, as shown in Figs. 2, 6, and 7.

In above step 104, the heat pipe 2 can be firstly subjected to flatten process and then bent according to the shape of the upper plate 11 and the lower plate 12.

In above-mentioned process, the isothermal plate assembly can be made with various shapes. The isothermal plate assembly is formed by assembling the upper plate 11 and the lower plate 12. The upper plate 11 and the lower plate 12 are preformed with predetermined bending shape. The heat pipe 2 also has corresponding bending shape and is placed between the upper plate 11 and the lower plate 12 for providing heat conduction. The isothermal plate assembly 1 with predetermined shape is further assembled with at least one heat-dissipating unit 3 having a plurality of heat-dissipating fins 31. The heat-dissipating unit 3 is attached to a concave portion of the isothermal plate assembly 1 by a hot melting process, Therefore, the heat-dissipating devices with isothermal plate assembly having multiple and various shapes can be made with simple and low cost process. The heat-dissipating devices with isothermal plate assembly can be easily adapted with various electronic devices.

The above-mentioned steps 102, 104 and 106 are interchangeable. That is, the heat pipe 2, the upper plate 11 and the lower plate 12 are bent before the heat pipe 2 is placed into the accommodation groove 13 formed between the upper plate 11 and the lower plate 12. Alternatively, the heat pipe 2 is firstly placed into the accommodation groove 13 formed between the upper plate 11 and the lower plate 12 and then bent together with the upper plate 11 and the lower plate 12. Moreover, a binding agent is selectively applied to contact faces between the heat pipe 2 and the upper plate 11 (and the lower plate 12). The binding agent fills the gap between the heat pipe 2 and the upper plate 11 (and the lower plate 12) by a following-up heating process.

In above-mentioned step 106, the step of applying binding agent to contact faces between the heat pipe 2 and the upper plate 11 (and the lower plate 12) can be eliminated if the hermetic degree between the heat pipe 2 and the upper plate 11 (and the lower plate 12) is sufficient. The step of applying binding agent to contact faces between the upper plate 11 and the lower plate 12 can also be eliminated in step 108. The thus-formed isothermal plate assembly 1 is further assembled with heat-dissipating unit 3 and then subjected to hot-melting and cooling process to form the heat-dissipating device with isothermal plate assembly 1 of various shapes.

The heat-dissipating device with isothermal plate assembly 1 of various shapes can be manufactured by above-mentioned method. The detailed structure of the heat-dissipating device with isothermal plate assembly will be described with reference to Figs. 2 to 7. Those figures show the heat-dissipating device with isothermal plate assembly for various embodiments.

The embodiments in Figs. 2 to 5 discloses heat-dissipating device with isothermal plate assembly for various shapes. The heat-dissipating device comprises an isothermal plate assembly 1 of various shapes, a bent flattened heat pipe 2 received in the isothermal plate assembly 1, and heat-dissipating unit 3 with shape corresponding to the isothermal plate assembly 1, as shown in Fig. 2.

The isothermal plate assembly 1 with one of various shapes is composed of an upper plate 11 and a lower plate 12. The isothermal plate assembly 1 can be formed by assembling an upper plate 11 and a lower plate 12 with predetermined geometric shape. The shape is, for example, L shape in Fig. 2, U shape in Fig. 6 or S shape in Fig. 7. Moreover, the isothermal plate assembly 1 comprises at least one concave portion 15 for assembling the heat-dissipating unit 3.

The upper plate 11 and the lower plate 12 are used form a closed isothermal plate assembly 1 and define an accommodation groove 13 therein for receiving the flattened heat pipe 2. In one preferred embodiment, at least one dent 14 is defined on either the upper plate 11 or the lower plate 12. The upper plate 11 or the lower plate 12 with the dent 14 is assembled with the lower plate 12 or the upper plate 11 with smooth face to form an isothermal plate assembly 1 with the accommodation groove 13, as shown in Fig. 3.

According to other preferred embodiment, both the upper plate 11 and the lower plate 12 are provided with dents 14, 14' to define the accommodation groove 13 when the upper plate and the lower plate 12 are assembled together, as shown in Fig. 4. Moreover, as shown in Fig. 5, the upper plate 11 and the lower plate 12 provided with dent 14, 14' are assembled by the help of outer coupling plates 111 and 121. The accommodation groove 13 is defined by the dents provided by the upper plate 11 and the lower plate 12.

The heat pipe 2 is placed in the accommodation groove 13 defined by the dents provided by the upper plate 11 and the lower plate 12 and is functioned to provide heat conduction. The heat pipe 2 is flattened to increase a contact surface between the upper plate 11 and the lower plate 12 and can be bent according to the shape of the upper plate 11 and the lower plate 12. Therefore, the heat pipe 2 has shape corresponding to the shape of the accommodation groove 13 between the upper plate 11 and the lower plate 12. The heat pipe 2 can be easily assembled into the accommodation groove 13, as shown in Figs. 2 to 5.

The heat-dissipating unit 3 is composed of a plurality of heat-dissipating fins 31 and assembled to the concave portion 15 of the isothermal plate assembly 1 of various shapes. Therefore, the heat-dissipating unit 3 is abutted to the concave portion 15 of the isothermal plate assembly 1 and can be assembled to the isothermal plate assembly 1 by melting the binding agent.

To sum up, the isothermal plate assembly 1 is composed of the upper plate 11, the lower plate 12, and the heat pipe 2. The upper plate 11, the lower plate 12, and the heat pipe 2 can be bent to predetermined shape to assemble to the isothermal plate assembly 1 with predetermined geometric shape. The heat-dissipating unit 3 with corresponding shape is abutted to the concave portion 15 of the isothermal plate assembly 1, thus forming the heat-dissipating device with isothermal plate assembly for various shapes, and suitable for various electronic devices and chassis.

Although the present invention has been described with reference to the preferred embodiment thereof, it will be understood that the invention is not limited to the details thereof. Various substitutions and modifications have suggested in the foregoing description, and other will occur to those of ordinary skill in the art. Therefore, all such substitutions and modifications are intended to be embraced within the scope of the invention as defined in the appended claims.

## Claims

1. A method for manufacturing heat-dissipating device with isothermal plate assembly (1) of a predetermined shape, the heat-dissipating device comprising an isothermal plate assembly (1) having an upper plate (11) and a lower plate (12) with the predetermined shape, and a bending heat pipe (2) placed therein, the heat-dissipating device further comprising a heat-dissipating unit (3) with the predetermined shape, the method comprising the steps of:
providing the upper plate (11) and the lower plate (12) with an accommodation groove (13) defined therein;
bending the upper plate (11) and the lower plate (12) to the predetermined shape;
providing the flattened heat pipe (2) and bending the flattened heat pipe (2) to the predetermined shape;
placing the bending heat pipe (2) into the accommodation groove (13) and assembling the upper plate (11) and the lower plate (12) to form the isothermal plate assembly (1) with a concave portion (15);
preparing the heat-dissipating unit (3) and assembling the heat-dissipating unit (3) to the isothermal plate assembly (1), applying a binding agent to a junction between the heat-dissipating unit (3) and the isothermal plate assembly (1);
sending the heat-dissipating unit (3) and the isothermal plate assembly (1) to an oven for melting the binding agent and forming a heat-dissipating device with the isothermal plate assembly (1);
removing and cooling the heat-dissipating device; and
finishing the manufacture of the heat-dissipating device.

2. The method as in claim 1, wherein the predetermined shape includes one of L shape, U shape, and S shape.

3. The method as in claim 1, further comprising the step of:
applying a binding agent on a contact face between the heat pipe (2) and the upper plate (11) and the lower plate (12), and another contact face between the upper plate (11) and the lower plate (12), the binding agent being melted in the hot-melting process to seal a gap between the heat pipe (2) and the upper plate (11) and the lower plate (12).

4. The method as in claim 1, further comprising the step of:
using outer coupling plates (111, 121) to clamp the upper plate (11) and the lower plate (12) together after the binding agent is applied;
after assembling the upper plate (11) and the lower plate (12) sending the assembled upper plate (11) and lower plate (12) to one of high temperature oven and re-flowing oven for a hot melting process; and
cooling the assembled upper plate (11) and lower plate (12).

5. A method for manufacturing heat-dissipating device with isothermal plate assembly (1) of a predetermined shape, the heat-dissipating device comprising an isothermal plate assembly (1) composed of an upper plate (11) and a lower plate (12) with the predetermined shape, and a bending heat pipe (2) placed therein, the heat-dissipating device further comprising a heat-dissipating unit (3) with the predetermined shape, the method comprising the steps of:
providing the upper plate (11) and the lower plate (12) with an accommodation groove (13) defined therein;
placing the flattened heat pipe (2) into the accommodation groove (13) and bending the flattened heat pipe (2) together with the upper plate (11) and the lower plate (12)to the predetermined shape;
assembling the upper plate (11) and the lower plate (12) to form the isothermal plate assembly (1) with a concave portion (15);
preparing the heat-dissipating unit (3) and assembling the heat-dissipating unit (3) to the isothermal plate assembly (1), applying a binding agent to a junction between the heat-dissipating unit (3) and the isothermal plate assembly (1) ;
sending the heat-dissipating unit 3 and the isothermal plate assembly (1) to an oven for melting the binding agent and forming a heat-dissipating device with the isothermal plate assembly (1);
removing and cooling the heat-dissipating device; and
finishing the manufacture of the heat-dissipating device.

6. A heat-dissipating device with isothermal plate assembly (1) of a predetermined shape, comprising:
an isothermal plate assembl (1) bent in a predetermined shape and having a concave portion (15);
an accommodation groove (13) defined in the isothermal plate assembly (1);
at least one bending heat pipe (2) being bent to the predetermined shape and placed into the accommodation groove (13); and
a heat-dissipating unit (3) assembled to the isothermal plate assembly (1) of the predetermined shape.

7. The heat-dissipating device as in claim 6, wherein one of the upper plate (11) and the lower plate (12) has at least one dent (14) defined thereon and is assembled with another one of the upper plate (11) and the lower plate (12) to define the accommodation groove (13) therein; alternatively both of the upper plate (11) and the lower plate (12) have at least one dent (14, 14') defined thereon and are assembled together to define the accommodation groove (13) therein.

8. The heat-dissipating device as in claim 7, further comprising outer coupling plates (111,121), wherein both of the upper plate (11) and the lower plate (12) have at least one dent (14, 14') defined thereon and are assembled together by the outer coupling plates (111, 121) to define the accommodation groove (13) therein.

9. The heat-dissipating device as in claim 6, wherein the heat-dissipating unit (3) is assembled to a concave portion (15) of the isothermal plate assembly (1).

10. The heat-dissipating device as in claim 6, wherein the bending heat pipe (2) is bent to the predetermined shape as the isothermal plate assembly (1).

11. The heat-dissipating device as in claim 6, wherein the heat-dissipating unit (3) is composed of a plurality of heat-dissipating fins (31) and assembled to the isothermal plate assembly (1) of the predetermined shape.

## Patentansprüche

1. Verfahren zum Herstellen einer Wärmeabführungsvorrichtung mit einer isothermischen Plattenbaugruppe (1) mit einer vorgegebenen Form, wobei die Wärmeabführungsvorrichtung eine isothermische Plattenbaugruppe (1) mit einer oberen Platte (11) und einer unteren Platte (12) mit der vorgegebenen Form und ein darin angeordnetes gebogenes Wärmerohr (2) umfasst, wobei die Wärmeabführungsvorrichtung ferner eine Wärmeabführungseinheit (3) mit der vorgegebenen Form umfasst, wobei das Verfahren die folgenden Schritte umfasst:
Versehen der oberen Platte (11) und der unteren Platte (12) mit einer darin definierten Aufnahmenut (13);
Biegen der oberen Platte (11) und der unteren Platte (12) in die vorgegebene Form;
Vorsehen des abgeflachten Wärmerohrs (2) und Biegen des abgeflachten Wärmerohrs (2) in die vorgegebene Form;
Anordnen des gebogenen Wärmerohrs (2) in der Aufnahmenut (13) und Zusammenfügen der oberen Platte (11) und der unteren Platte (12), um die isothermische Plattenbaugruppe (1) mit einem konkaven Abschnitt (15) zu bilden;
Vorbereiten der Wärmeabführungseinheit (3) und Zusammenfügen der Wärmeabführungseinheit (3) mit der isothermischen Plattenbaugruppe (1) und Aufbringen eines Bindemittels auf einen Übergang zwischen der Wärmeabführungseinheit (3) und der isothermischen Plattenbaugruppe (1);
Schicken der Wärmeabführungseinheit (3) und der isothermischen Plattenbaugruppe (1) zu einem Ofen, um das Bindemittel zu schmelzen und um eine Wärmeabführungsvorrichtung mit der isothermischen Plattenbaugruppe (1) zu bilden;
Entfernen und Kühlen der Wärmeabführungsvorrichtung; und
Beenden der Herstellung der Wärmeabführungsvorrichtung.

2. Verfahren nach Anspruch 1, bei dem die vorgegebene Form eine L-Form, eine U-Form und eine S-Form umfasst.

3. Verfahren nach Anspruch 1, das ferner den folgenden Schritt umfasst:
Aufbringen eines Bindemittels auf eine Kontaktfläche zwischen dem Wärmerohr (2) und der oberen Platte (11) und der unteren Platte (12) und eine weitere Kontaktfläche zwischen der oberen Platte (11) und der unteren Platte (12), wobei das Bindemittel in dem Heißschmelzprozess geschmolzen wird, um einen Spalt zwischen dem Wärmerohr (2) und der oberen Platte (11) und der unteren Platte (12) abzudichten.

4. Verfahren nach Anspruch 1, das ferner den folgenden Schritt umfasst:
Verwenden äußerer Kopplungsplatten (111, 121), um die obere Platte (11) und die untere Platte (12) zusammenzuklemmen, nachdem das Bindemittel aufgebracht worden ist;
nach dem Zusammenfügen der oberen Platte (11) und der unteren Platte (12) Senden der oberen Platte (11) und der unteren Platte (12), die zusammengefügt sind, zu einem Hochtemperaturofen und einem Rückflussofen für einen Heizschmelzprozess; und
Kühlen der mit der unteren Platte (12) zusammengefügten oberen Platte (11).

5. Verfahren zum Herstellen einer Wärmeabführungsvorrichtung mit einer isothermischen Plattenbaugruppe (1) einer vorgegebenen Form, wobei die Wärmeabführungsvorrichtung eine isothermische Plattenbaugruppe (1), die aus einer oberen Platte (11) und einer unteren Platte (12) mit der vorgegebenen Form aufgebaut ist, und ein darin angeordnetes gebogenes Wärmerohr (2) umfasst, wobei die Wärmeabführungsvorrichtung ferner eine Wärmeabführungseinheit (3) mit der vorgegebenen Form umfasst, wobei das Verfahren die folgenden Schritte umfasst:
Versehen der oberen Platte (11) und der unteren Platte (12) mit einer darin definierten Aufnahmenut (13);
Anordnen des abgeflachten Wärmerohrs (2) in der Aufnahmenut (13) und Biegen des abgeflachten Wärmerohrs (2) zusammen mit der oberen Platte (11) und der unteren Platte (12) in die vorgegebene Form;
Zusammenfügen der oberen Platte (11) und der unteren Platte (12), um die isothermische Plattenbaugruppe (1) mit einem konkaven Abschnitt (15) zu formen;
Vorbereiten der Wärmeabführungseinheit (3) und Zusammenfügen der Wärmeabführungseinheit (3) mit der isothermischen Plattenbaugruppe (1) und Aufbringen eines Bindemittels auf einen Übergang zwischen der Wärmeabführungseinheit (3) und der isothermischen Plattenbaugruppe (1);
Senden der Wärmeabführungseinheit (3) und der isothermischen Plattenbaugruppe (1) zu einem Ofen, um das Bindemittel zu schmelzen und um eine Wärmeabführungsvorrichtung mit der isothermischen Plattenbaugruppe (1) zu formen;
Entfernen und Kühlen der Wärmeabführungsvorrichtung; und
Beenden der Herstellung der Wärmeabführungsvorrichtung.

6. Wärmeabführungsvorrichtung mit isothermischer Plattenbaugruppe nach Anspruch 1 mit einer vorgegebenen Form, die umfasst:
eine isothermische Plattenbaugruppe (1), die in eine vorgegebene Form gebogen ist und einen konkaven Abschnitt (15) besitzt;
eine Aufnahmenut (13), die in der isothermischen Plattenbaugruppe (1) definiert ist;
wenigstens ein gebogenes Wärmerohr (2), das in die vorgegebene Form gebogen ist und in der Aufnahmenut (13) angeordnet ist; und
eine Wärmeabführungseinheit (3), die mit der isothermischen Plattenbaugruppe (1) mit der vorgegebenen Form zusammengefügt ist.

7. Wärmeabführungsvorrichtung nach Anspruch 6, bei der entweder die obere Platte (11) oder die untere Platte (12) wenigstens einen daran definierten Zahn (14) besitzt und mit der jeweils anderen oberen Platte (11) bzw. der unteren Platte (12) zusammengefügt ist, um darin die Aufnahmenut (13) zu definieren; wobei alternativ sowohl die obere Platte (11) als auch die untere Platte (12) wenigstens einen daran definierten Zahn (14, 14') besitzen und zusammengefügt sind, um darin die Aufnahmenut (13) zu bilden.

8. Wärmeabführungsvorrichtung nach Anspruch 7, die ferner äußere Kopplungsplatten (111, 121) umfasst, wobei sowohl die obere Platte (11) als auch die untere Platte (12) wenigstens einen daran definierten Zahn (14, 14') besitzen und durch die äußeren Kopplungsplatten (111, 121) zusammengefügt sind, um darin die Aufnahmenut (13) zu definieren.

9. Wärmeabführungsvorrichtung nach Anspruch 6, bei der die Wärmeabführungseinheit (3) mit einem konkaven Abschnitt (15) der isothermischen Plattenbaugruppe (1) zusammengefügt ist.

10. Wärmeabführungsvorrichtung nach Anspruch 6, bei der das gebogene Wärmerohr (2) in die vorgegebene Form wie die isothermische Plattenbaugruppe (1) gebogen ist.

11. Wärmeabführungsvorrichtung nach Anspruch 6, bei der die Wärmeabführungseinheit (3) aus mehreren Wärmeabführungsrippen (31) aufgebaut ist und mit der isothermischen Plattenbaugruppe (1) mit der vorgegebenen Form zusammengefügt ist.

## Revendications

1. Un procédé de fabrication d'un dispositif dissipateur de chaleur avec un ensemble de plaque isothermique (1) à forme prédéterminée, le dispositif dissipateur de chaleur comprenant un ensemble de plaque isothermique (1) ayant une plaques supérieure (11) et une plaques inférieure (12) ayant la forme prédéterminée, et un type à chaleur (2) de coudage y étant placé, le dispositif dissipateur de chaleur comprenant en outre une unité de dissipation (3) ayant la forme prédéterminée, le procédé comprenant les étapes consistant à :
- fournir à la plaque supérieure (11) et à la plaque inférieure (12) une gorge de logement (13) définie en son sein ;
- couder la plaque supérieure (11) et la plaque inférieure (12) à la forme prédéterminée ;
- fournir le tube à chaleur (11) aplati, et couder le tube à chaleur (2) aplati à la forme prédéterminée ;
- placer le tube à chaleur (2) à coudage dans la gorge de logement (13) et assembler la plaque supérieure (11) et la plaque inférieure (12) pour former l'ensemble de plaque isothermique (1), muni d'une partie concave (15) ;
- préparer l'unité de dissipation de chaleur (3) et assembler l'unité de dissipation de chaleur (3) avec l'ensemble de plaque isothermique (1), appliquer un agent de liaison à une jonction entre l'unité de dissipation de chaleur (3) et l'ensemble de plaque isothermique (1) ;
- transporter l'unité de dissipation de chaleur (3) et l'ensemble de plaque isothermique (1) en un four pour faire fondre l'agent de liaison et former un dispositif dissipateur de chaleur muni de l'ensemble de plaque isothermique (1) ;
- enlever et refroidir le dispositif dissipateur de chaleur ; et
- finir la fabrication du dispositif dissipateur de chaleur.

2. Le procédé tel qu'indiqué à la revendication 1, dans lequel la forme prédéterminée comprend l'une parmi la forme en L, la forme en U, et la forme en S.

3. Le procédé tel qu'indiqué à la revendication 1, comprenant en outre l'étape consistant à :
- appliquer un agent de liaison sur une face de contact entre le tube à chaleur (2) et la plaque supérieure (11) et la plaque inférieure (12), et une autre face de contact entre la plaque supérieure (11) et la plaque inférieure (12), l'agent de liaison étant fondu dans le processus de fusion à chaud pour fermer hermétiquement un intervalle entre le tube à chaleur (2) et la plaque supérieure (11) et la plaque inférieure (12).

4. Le procédé tel qu'indiqué à la revendication 1, comprenant en outre l'étape consistant à :
- utiliser des plaques de couplage extérieures (111, 121) pour serrer la plaque supérieure (11) et la plaque inférieure (12) ensemble après avoir appliqué l'agent de liaison ;
- après assemblage de la plaque supérieure (11) et la plaque inférieure (12), envoyer la plaque supérieure (11) et la plaque inférieure (12) assemblées à l'un parmi un four à haute température et un four de remise en fusion, pour effectuer un processus de fusion à chaud ; et
- refroidir la plaque supérieure (11) et la plaque inférieure (12) assemblées.

5. Un procédé de fabrication d'un dispositif dissipateur de chaleur avec un ensemble de plaque isothermique (1) à forme prédéterminée, le dispositif dissipateur de chaleur comprenant un ensemble de plaque isothermique (1), composé d'une plaque supérieure (11) et d'une plaque inférieure (12) et ayant la forme prédéterminée, et un tube à chaleur à coudage (2) y étant placé, le dispositif dissipateur de chaleur comprenant en outre une unité de dissipation de chaleur (3) ayant la forme prédéterminée, le procédé comprenant les étapes consistant à :
- fournir la plaque supérieure (11) et la plaque inférieure 12 avec une gorge de logement (13) définie y étant définie;
- placer le tube à chaleur (2) aplati dans la gorge de logement (13) et couder le tube à chaleur (2) aplati conjointement avec la plaque supérieure (11) et la plaque inférieure (12), à la forme prédéterminée ;
- assembler la plaque supérieure (11) et la plaque inférieure (12) pour former l'ensemble de plaque isothermique (1) ayant une partie concave (15) ;
- préparer l'unité de dissipation de chaleur (3) et assembler l'unité de dissipation de chaleur (3) à l'ensemble de plaque isothermique (1), appliquer un agent de liaison à une jonction entre l'unité de dissipation de chaleur (3) et l'ensemble de plaque isothermique (1) ;
- envoyer l'unité de dissipation de chaleur (3) et l'ensemble de plaque isothermique (1) à un four, pour mettre en fusion l'agent de liaison et former un dispositif dissipateur de chaleur ayant l'ensemble de plaque isothermique (1) ;
- enlever et refroidir le dispositif dissipateur de chaleur ; et
- finir la fabrication du dispositif dissipateur de chaleur.

6. Un dispositif dissipateur de chaleur ayant un ensemble de plaque isothermique (1) à forme prédéterminé comprenant :
- un ensemble de plaque isothermique (1) coudé à une forme prédéterminée et comprenant une partie concave (15) ;
- une gorge de logement (13) définie dans l'ensemble de plaque isothermique (1);
- au moins un tube de chaleur à coudage (2) étant coudé à la forme prédéterminée et placé dans la gorge de logement (13) ; et
- une unité de dissipation de chaleur (3) assemblée à l'ensemble de plaque isothermique (1) ayant la forme prédéterminée.

7. Le dispositif dissipateur de chaleur tel qu'indiqué à la revendication 6, dans lequel l'une, de la plaque supérieure (11) et de la plaque inférieure (12), comprend au moins une indentation (14) définie sur elle, et est assemblée à une autre de la plaque supérieure (11) et de la plaque inférieure (12) pour définir en son sein la gorge de logement (13) ; en variante, les deux de la plaque supérieure (11) et de la plaque inférieure (12) ayant au moins une indentation (14, 14') définie sur elle et étant assemblées ensemble pour définir en leur sein la gorge de logement (13).

8. Le dispositif dissipateur de chaleur tel qu'indiqué à la revendication 7, comprenant en outre des plaques de couplage extérieures (111, 121) dans lesquelles les deux de la plaque supérieure (11) et la plaque inférieure (12) ont au moins une indentation (14, 14') définie en leur sein et sont assemblées ensemble par des plaques de couplage extérieures (111, 121) pour définir en leur sein la gorge de logement (13).

9. Le dispositif dissipateur de chaleur tel qu'indiqué à la revendication 6, dans lequel l'unité de dissipation de chaleur (3) est assemblée en une partie concave (15) de l'ensemble de plaque isothermique (1).

10. Le dispositif dissipateur de chaleur tel qu'indiqué à la revendication 1, dans lequel le tube à chaleur (2) à coudage est coudé à la forme prédéterminée, telle que celle de l'ensemble de plaque isothermique (1).

11. Le dispositif dissipateur de chaleur tel qu'indiqué à la revendication 6, dans lequel l'unité de dissipation de chaleur (3) est composée d'une pluralité d'ailettes de dissipation de chaleur (31) et est assemblée en produisant l'ensemble de plaque isothermique (1) à la forme prédéterminée.
